(19) **Europäisches Patentamt / European Patent Office / Office européen des brevets**

(11) **EP 2 039 733 A1**

(12) # EUROPEAN PATENT APPLICATION

(43) Date of publication:
**25.03.2009 Bulletin 2009/13**

(21) Application number: **08022204.5**

(22) Date of filing: **11.04.2006**

(51) Int Cl.:
*C09G 1/02* *(2006.01)*     *C30B 33/00* *(2006.01)*
*H01L 21/306* *(2006.01)*

(84) Designated Contracting States:
**DE FR GB**

(30) Priority: **26.04.2005 JP 2005127730**

(62) Document number(s) of the earlier application(s) in accordance with Art. 76 EPC:
**06007612.2 / 1 717 286**

(71) Applicant: **Sumitomo Electric Industries, Ltd. Osaka-shi, Osaka 541-0041 (JP)**

(72) Inventors:
• **Ishibashi, Keiji**
**Itami-shi**
**Hyogo (JP)**

• **Nishiura, Takayuki**
**Itami-shi**
**Hyogo (JP)**

(74) Representative: **Grünecker, Kinkeldey, Stockmair & Schwanhäusser Anwaltssozietät Leopoldstrasse 4 80802 München (DE)**

Remarks:
This application was filed on 19-12-2008 as a divisional application to the application mentioned under INID code 62.

(54) **Method of surface treatment of group III nitride crystal film, group III nitride crystal substrate, group III nitride crystal substrate with epitaxial layer, and semiconductor device**

(57) A Group III nitride crystal substrate wherein the surface roughness Ry is 5nm or less.

## FIG. 1

EP 2 039 733 A1

**Description**

BACKGROUND OF THE INVENTION

Field of the Invention

The present invention relates to a method of surface treatment of a Group III nitride crystal film used for substrates of semiconductor devices such as a light-emitting device, an electronic device, and a semiconductor sensor. Furthermore, the present invention relates to a Group III nitride crystal substrate prepared by the method of surface treatment of the Group III nitride crystal film.

Description of the Background Art

Group III nitride crystals such as a GaN crystal and an AlN crystal are very useful materials for producing substrates of semiconductor devices such as a light-emitting device, an electronic device, and a semiconductor sensor. Herein, the term "Group III nitride crystals" refers to crystals composed of a Group III element and nitrogen, e.g., $Ga_xAl_yIn_{1-x-y}N$ crystals ($0 \leq x$, $0 \leq y$, and $x + y \leq 1$).
A Group III nitride crystal substrate used as a substrate of a semiconductor device is prepared by forming a shape on the periphery of a Group III nitride crystal film, slicing the crystal film so as to have a predetermined thickness, and mechanically lapping (or polishing) or mechanically grinding the surface. However, by the slicing, mechanical lapping, or mechanical grinding, a thick affected layer (the term "affected layer" means a layer in which crystal lattices are out of order, the layer being formed on the surface of a crystal film by grinding, lapping, or polishing of the surface of the crystal film, hereinafter the same) is formed on the surface of the Group III nitride crystal film, or the surface roughness of the Group III nitride crystal film is increased. As the thickness of the affected layer of the Group III nitride crystal substrate increases, and as the surface roughness thereof increases, the surface quality of the substrate degrades, resulting in an increase in surface irregularities of a Group III nitride crystal layer, which is formed on the surface of the Group III nitride crystal film by epitaxial growth, and a decrease in the crystallinity. Therefore, semiconductor devices with satisfactory quality cannot be formed on such a substrate.
Consequently, as a method for producing a Group III nitride crystal substrate from a Group III nitride crystal film, a method of slicing the Group III nitride crystal film so as to have a predetermined thickness, mechanically lapping or mechanically grinding the surface, and then polishing the surface by dry etching (see, for example, Japanese Unexamined Patent Application Publication No. 2001-322899) or chemical mechanical polishing (CMP) (see, for example, U. S. Patent Nos. 6,596,079 and 6,488,767, and Japanese Unexamined Patent Application Publication No. 2004-311575), thereby removing the affected layer and further reducing the surface roughness has been widely employed.
However, in the method of dry-etching the surface of the Group III nitride crystal substrate, although the affected layer can be removed, it is difficult to further decrease the surface roughness.
In the known polishing, the surface of a Group III nitride crystal film is polished by pressing the Group III nitride crystal film on a polishing pad, while a slurry containing abrasive grains having a hardness lower than or equal to the hardness of the Group III nitride crystal film to be polished is supplied on the polishing pad. However, since the Group III nitride crystal film is hard and has low reactivity, the polishing rate is very low and such a known polishing is an inefficient method.
Recently, a method of polishing a Group III nitride crystal film using a slurry containing hard abrasive grains composed of diamond, alumina ($Al_2O_3$), or the like and soft abrasive grains composed of colloidal silica ($SiO_2$), fumed titania ($TiO_2$), or the like has been proposed (see, for example, Japanese Unexamined Patent Application Publication No. 2004-311575). This technology can increase the polishing rate of the Group III nitride crystal film and the surface smoothness. However, in the polishing method disclosed in Japanese Unexamined Patent Application Publication No. 2004-311575, it is difficult to further improve the surface smoothness because the slurry contains hard abrasive grains. Therefore, a polishing method in which a smoother surface can be produced while high polishing rate is maintained is desired.

SUMMARY OF THE INVENTION

In order to efficiently produce a Group III nitride crystal substrate that can be used for semiconductor devices, it is an object of the present invention to provide a method of surface treatment of a Group III nitride crystal film in which a satisfactory quality smooth surface with a thin affected layer can be efficiently formed on the Group III nitride crystal film.
The present invention provides a method of surface treatment of a Group III nitride crystal film including polishing a surface of the Group III nitride crystal film, wherein a pH value x and an oxidation-reduction potential value y (mV) of a polishing liquid used for the polishing satisfy both relationships of $y \geq -50x + 1,000$ (Ex. (1)) and $y \leq -50x + 1,900$ (Ex. (2)).

In the method of surface treatment of a Group III nitride crystal film of the present invention, the polishing liquid may contain an oxidizing agent. In addition, the pH of the polishing liquid may be up to 6 or at least 8.

In the method of surface treatment of a Group III nitride crystal film of the present invention, the polishing liquid may contain abrasive grains and the abrasive grains may be high-hardness abrasive grains having a hardness higher than that of the Group III nitride crystal film, low-hardness abrasive grains having a hardness lower than or equal to that of the Group III nitride crystal film, or mixed abrasive grains containing the high-hardness abrasive grains and the low-hardness abrasive grains. The grain size of the high-hardness abrasive grains may be 1 $\mu$m or less. The high-hardness abrasive grains may be abrasive grains containing at least one material selected from the group consisting of diamond, SiC, $Si_3N_4$, BN, $Al_2O_3$, $Cr_2O_3$, and $ZrO_2$. The low-hardness abrasive grains may be abrasive grains containing at least one material selected from the group consisting of $SiO_2$, $CeO_2$, $TiO_2$, MgO, $MnO_2$, $Fe_2O_3$, $Fe_3O_4$, NiO, ZnO, CoO, $Co_3O_4$, $SnO_2$, CuO, $Cu_2O$, $GeO_2$, CaO, $Ga_2O_3$, and $In_2O_3$.

In the method of surface treatment of a Group III nitride crystal film of the present invention, a surface of the Group III nitride crystal film may be mechanically ground or mechanically lapped and the mechanically ground or mechanically lapped surface of the Group III nitride crystal film may then be polished. The thickness of an affected layer after the polishing of the Group III nitride crystal film may be 50 nm or less. The surface roughness Ry after the polishing of the Group III nitride crystal film may be 5 nm or less. The surface roughness Ra after the polishing of the Group III nitride crystal film may be 0.5 nm or less. Furthermore, the Group III nitride crystal film after the polishing may be subjected to thermal annealing.

The present invention provides a Group III nitride crystal substrate prepared by the above method of surface treatment. The present invention also provides a Group III nitride crystal substrate wherein the surface roughness Ry is 1 nm or less. The present invention also provides a Group III nitride crystal substrate wherein the surface roughness Ra is 0.1 nm or less.

In the Group III nitride crystal substrate of the present invention, a principal plane of the Group III nitride crystal substrate may be parallel to any plane of C-plane, A-plane, R-plane, M-plane, and S-plane in the wurtzite structure. An off-angle formed by a principal plane of the Group III nitride crystal substrate and any plane of C-plane, A-plane, R-plane, M-plane, and S-plane in the wurtzite structure may be 0.05° to 15°.

The present invention provides a Group III nitride crystal substrate with an epitaxial layer, the substrate including the above Group III nitride crystal substrate, and at least one Group III nitride layer formed on the Group III nitride crystal substrate by epitaxial growth.

The present invention provides a semiconductor device including the above Group III nitride crystal substrate. Furthermore, the present invention provides the semiconductor device further including a light-emitting element including a semiconductor layer composed of three or more sublayers formed on a principal plane of the Group III nitride crystal substrate by epitaxial growth, a first electrode formed on another principal plane of the Group III nitride crystal substrate, and a second electrode formed on the outermost semiconductor sublayer of the semiconductor layer; and an electrical conductor mounting the light-emitting element, wherein, in the light-emitting element, the face adjacent to the Group III nitride crystal substrate serves as a light-emitting face and the face adjacent to the outermost semiconductor sublayer serves as a mounting face, and the semiconductor layer includes a p-type semiconductor sublayer, an n-type semiconductor sublayer, and a light-emitting sublayer formed between the p-type semiconductor sublayer and the n-type semiconductor sublayer.

According to the present invention, a satisfactory quality smooth surface with a thin affected layer can be efficiently formed on a Group III nitride crystal film, and thus a Group III nitride crystal substrate that can be used for semiconductor devices can be efficiently produced.

BRIEF DESCRIPTION OF THE DRAWINGS

Figure 1 is a schematic cross-sectional view showing a method of polishing a surface of a Group III nitride crystal film used in the present invention;

Figure 2 is a schematic cross-sectional view showing a method of mechanically grinding the surface of the Group III nitride crystal film used in the present invention;

Figure 3 is a schematic cross-sectional view showing a method of mechanically lapping the surface of the Group III nitride crystal film used in the present invention; and

Figure 4 is a schematic cross-sectional view showing a semiconductor device according to an embodiment of the present invention.

DETAILED DESCRIPTION OF THE INVENTION

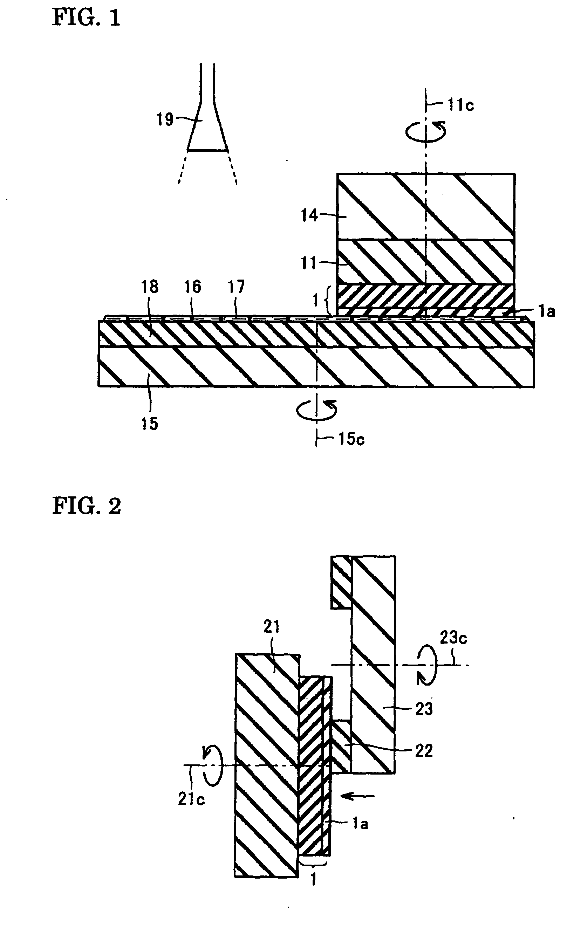

According to a method of surface treatment of a Group III nitride crystal film of the present invention, referring to Fig. 1, in a method of surface treatment of a Group III nitride crystal film 1 for polishing a surface of the Group III nitride crystal film 1, a pH value x and an oxidation-reduction potential value y (mV) of a polishing liquid 17 used for polishing satisfy both relationships represented by Ex. (1) and Ex. (2):

$$y \geq -50x + 1,000 \quad \cdots (1)$$

$$y \leq -50x + 1,900 \quad \cdots (2).$$

Herein, the term "polishing" means to chemically and /or mechanically smooth a surface of an object to be polished using a polishing liquid. For example, referring to Fig. 1, the polishing liquid 17 is supplied from a polishing liquid feed opening 19 on a polishing pad 18, while the polishing pad 18 fixed on a surface plate 15 is rotated around a rotation axis 15c. A weight 14 is disposed on a crystal holder 11 that fixes the Group III nitride crystal film 1. The Group III nitride crystal film 1 is pressed on the polishing pad 18, while the Group III nitride crystal film 1 is rotated around a rotation axis 11c with the crystal holder 11 and the weight 14. Thereby, the surface of the Group III nitride crystal film 1 can be polished.

The term "oxidation-reduction potential" means an energy level (electric potential) determined by an equilibrium state between an oxidizing agent and a reductant that coexist in a solution. The oxidation-reduction potential determined by a measurement is a value relative to a reference electrode. An apparent measured value of a solution depends on the type of the reference electrode. In general scientific papers and the like, a normal hydrogen electrode (N.H.E) is often used as the reference electrode. The oxidation-reduction potential in the present invention is represented as a value when the normal hydrogen electrode (N.H.E) is used as the reference electrode.

In the method of surface treatment of a Group III nitride crystal film according to the present invention, if the pH value x and the oxidation-reduction potential value y (mV) of the polishing liquid 17 satisfy y < -50x + 1,000, the oxidizing power of the polishing liquid 17 is weak, resulting in a decrease in the polishing rate of the surface of the Group III nitride crystal film 1. On the other hand, if y > -50x + 1,900, the oxidizing power becomes excessively strong and a corrosion action to polishing equipment such as the polishing pad and the surface plate becomes strong, resulting in a difficulty in a stable polishing.

Furthermore, from the viewpoint that a high polishing rate is maintained, the relationship y ≥ -50x + 1,300 is preferably satisfied. In other words, the pH value x and the oxidation-reduction potential value y (mV) of the polishing liquid 17 preferably satisfy both relationships represented by Ex. (2) and Ex. (3):

$$y \leq -50x + 1,900 \quad \cdots (2)$$

$$y \geq -50x + 1,300 \quad \cdots (3).$$

Acids such as hydrochloric acid and sulfuric acid and bases such as KOH and NaOH, which are contained in a normal polishing liquid, have a weak power for oxidizing a surface of a chemically stable Group III nitride crystal film and removing the affected layer. Therefore, preferably, an oxidizing agent is added to the polishing liquid to increase the oxidation-reduction potential, i.e., to increase the oxidizing power. The amount of the oxidizing agent added is adjusted such that the pH value x and the oxidation-reduction potential value y (mV) of the polishing liquid 17 satisfy both relationships of y ≥ -50x + 1,000 (Ex. (1)) and y ≤ -50x + 1,900 (Ex. (2)).

From the viewpoint that the polishing rate is increased, preferred examples of the oxidizing agent added to the polishing liquid include, but are not limited to, hypochlorous acid, chlorinated isocyanuric acids such as trichloroisocyanuric acid, chlorinated isocyanurates such as sodium dichloroisocyanurate, permanganates such as potassium permanganate, dichromates such as potassium dichromate, bromates such as potassium bromate, thiosulfates such as sodium thiosulfate, nitric acid, an aqueous hydrogen peroxide, and ozone. These oxidizing agents may be used alone or in combination of two or more oxidizing agents.

The pH of the polishing liquid 17 used in the present invention is preferably up to 6 or at least 8. An acidic polishing liquid with a pH of up to 6 or a basic polishing liquid with a pH of at least 8 is brought into contact with the Group III nitride crystal film to remove the affected layer of the Group III nitride crystal film by etching, thereby increasing the polishing rate. From this viewpoint, the pH of the polishing liquid 17 is more preferably up to 4 or at least 10 and further preferably up to 2.

Acids and bases used for adjusting the pH are not particularly limited. Examples thereof include inorganic acids such as hydrochloric acid, nitric acid, sulfuric acid, and phosphoric acid; organic acids such as formic acid, acetic acid, citric acid, malic acid, tartaric acid, succinic acid, phthalic acid, and fumaric acid; bases such as KOH, NaOH, $NH_4OH$, and amines; salts such as sulfates, carbonates, and phosphates. Alternatively, the pH may be adjusted by adding the oxidizing agent.

Preferably, the polishing liquid used in the present invention contains abrasive grains. These abrasive grains can increase the polishing rate. The abrasive grains that can be contained in the polishing liquid are not particularly limited, and examples thereof include high-hardness abrasive grains having a hardness higher than that of the Group III nitride crystal film, low-hardness abrasive grains having a hardness lower than or equal to that of the Group III nitride crystal film, and mixed abrasive grains containing the high-hardness abrasive grains and the low-hardness abrasive grains.

In the polishing according to the present invention, use of the high-hardness abrasive grains can further increase the polishing rate and use of the low-hardness abrasive grains can improve the morphology of the crystal surface. Use of the mixed abrasive grains containing the high-hardness abrasive grains and the low-hardness abrasive grains can form a satisfactory quality smooth crystal film surface with a thin affected layer, while a high polishing rate is maintained.

From the above viewpoint, regarding the abrasive grains in the polishing liquid, the mixing volume ratio of the high-hardness abrasive grains and the low-hardness abrasive grains is preferably high-hardness abrasive grains:low-hardness abrasive grains = 5:95 to 50:50 and more preferably 10:90 to 30:70.

In the polishing according to the present invention, the grain size of the high-hardness abrasive grains is preferably 1 $\mu$m or less. A surface of the Group III nitride crystal film is mechanically removed by the high-hardness abrasive grains to polish the surface. Accordingly, by decreasing the grain size of the high-hardness abrasive grains, the depths of scratches and irregularities that are formed on the surface of the Group III nitride crystal film can be decreased. Thus, the surface can be further smoothed. From this viewpoint, the grain size of the high-hardness abrasive grains is more preferably 0.5 $\mu$m or less.

The high-hardness abrasive grains are not particularly limited as long as the abrasive grains have a hardness higher than that of the Group III nitride crystal film to be polished. The high-hardness abrasive grains are preferably abrasive grains containing at least one material selected from the group consisting of diamond, SiC, $Si_3N_4$, BN, $Al_2O_3$, $Cr_2O_3$, and $ZrO_2$. Use of high-hardness abrasive grains containing these materials can increase the polishing rate during the polishing of the surface of the Group III nitride crystal film.

The low-hardness abrasive grains are not particularly limited as long as the abrasive grains have a hardness lower than or equal to that of the Group III nitride crystal film to be polished. The low-hardness abrasive grains are preferably abrasive grains containing at least one material selected from the group consisting of $SiO_2$, $CeO_2$, $TiO_2$, MgO, $MnO_2$, $Fe_2O_3$, $Fe_3O_4$, NiO, ZnO, CoO, $Co_3O_4$, $SnO_2$, CuO, $Cu_2O$, $GeO_2$, CaO, $Ga_2O_3$, and $In_2O_3$. Use of low-hardness abrasive grains containing these materials can improve the quality of a surface formed by the polishing of the Group III nitride crystal film. The phrase "the quality of a surface is improved" means that the surface roughness decreases and/or the thickness of the affected layer decreases. On the other hand, the phrase "the quality of a surface is degraded" means that the surface roughness increases and/or the thickness of the affected layer increases.

The abrasive grains are not limited to oxides containing a single metal element and may be oxides containing two or more metal elements (for example, oxides having a structure of ferrite, perovskite, spinel, or ilmenite). Nitrides such as AlN, GaN, and InN; carboxides such as $CaCOs$ and $BaCo_3$, metals such as Fe, Cu, Ti, and Ni; and carbons (specifically, carbon black, carbon nanotubes, C60, and the like) may also be used.

In the method of surface treatment of a Group III nitride crystal film according to the present invention, a surface of the Group III nitride crystal film may be mechanically ground or mechanically lapped, and the mechanically ground or mechanically lapped surface of the Group III nitride crystal film may then be polished. By combining the mechanical grinding or the mechanical lapping prior to the polishing, the polishing rate of the surface of the Group III nitride crystal film can be increased and a satisfactory quality smooth surface of the Group III nitride crystal film with a thin affected layer can be formed.

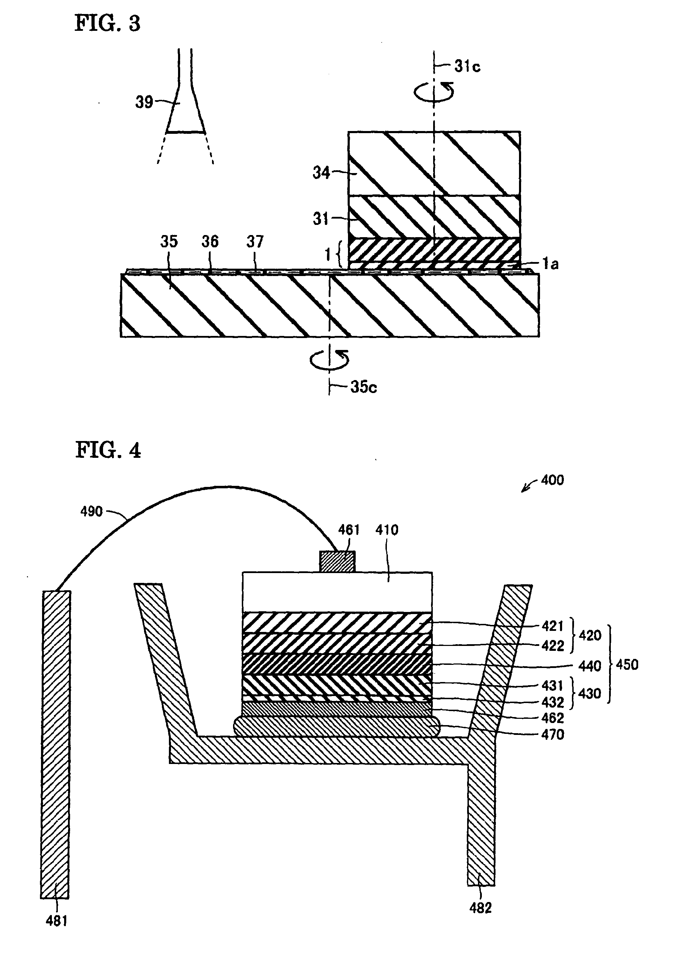

The mechanical grinding will now be described. For example, referring to Fig. 2, a grinding wheel 22 produced by bonding abrasive grains with a bond is moved to a surface of a Group III nitride crystal film 1, which is fixed to a crystal holder 21 and is rotated around a rotation axis 21c, while the grinding wheel 22 fixed to a grinding wheel base 23 is rotated around a rotation axis 23c. Thereby, the surface of the Group III nitride crystal film 1 is smoothed while being ground. The mechanical lapping will now be described. For example, referring to Fig. 3, a slurry 37 prepared by dispersing abrasive grains 36 therein is supplied from a slurry feed opening 39 on a surface plate 35, while the surface plate 35 is rotated around a rotation axis 35c. In addition, a weight 34 is disposed on a crystal holder 31 that fixes a Group III nitride crystal film 1. The Group III nitride crystal film 1 is pressed on the surface plate 35, while the Group III nitride crystal film 1 is rotated around a rotation axis 31c with the crystal holder 31 and the weight 34. Thereby, the surface of the Group III nitride crystal film 1 is smoothed. In the mechanical lapping, instead of using the slurry prepared by dispersing abrasive grains, although not shown in the figure, the above-described grinding wheel produced by bonding abrasive grains with a bond may be pressed on the Group III nitride crystal film while the grinding wheel is rotated, thereby polishing the surface of the Group III nitride crystal film.

In the method of surface treatment of a Group III nitride crystal film according to the present invention, referring to Fig. 1, the thickness of an affected layer 1a after the polishing of the Group III nitride crystal film 1 is preferably 50 nm or less. When the thickness of the affected layer after the polishing of the Group III nitride crystal film is 50 nm or less, an epitaxial layer (which means a layer formed by epitaxial growth, hereinafter the same) having satisfactory morphology and crystallinity can be formed on the Group III nitride crystal film. From this viewpoint, the thickness of the affected layer is more preferably 10 nm or less. Herein, the term "satisfactory crystallinity" means a state close to an ideal crystal structure in which the distribution of the size and/or the distribution of the shift of plane direction is small with respect to each crystal lattice in the crystal. For example, the smaller the half-width of the rocking curve in X-ray diffraction is, the better the crystallinity is.

In the method of surface treatment of a Group III nitride crystal film according to the present invention, the surface roughness Ry after the polishing of the Group III nitride crystal film is preferably 5 nm or less. In the present invention, the term "surface roughness Ry" means the following. An area of 10 $\mu$m square (10 $\mu$m $\times$ 10 $\mu$m = 100 $\mu$m$^2$, hereinafter the same) is extracted as a reference area from a roughness curved surface in a direction of the average surface. The sum of the height from the average surface of the extracted part to the highest point and the depth from the average surface to the lowest point is referred to as surface roughness Ry. When the surface roughness Ry after the polishing of the Group III nitride crystal film is 5 nm or less, an epitaxial layer having satisfactory morphology and crystallinity can be formed on the Group III nitride crystal film. From this viewpoint, the surface roughness Ry is more preferably 1 nm or less.

In the method of surface treatment of a Group III nitride crystal film according to the present invention, the surface roughness Ra after the polishing of the Group III nitride crystal film is preferably 0.5 nm or less. In the present invention, the term "surface roughness Ra" means the following. An area of 10 $\mu$m square is extracted as a reference area from a roughness curved surface in a direction of the average surface. A value calculated by summing up the absolute values of deviation from the average surface to the measured curved surface of the extracted part and averaging the sum by the reference area is referred to as surface roughness Ra. When the surface roughness Ra after the polishing of the Group III nitride crystal film is 0.5 nm or less, an epitaxial layer having satisfactory morphology and crystallinity can be formed on the Group III nitride crystal film. From this viewpoint, the surface roughness Ra is more preferably 0.1 nm or less.

In the method of surface treatment of a Group III nitride crystal film according to the present invention, the thickness of a surface oxidized layer after the polishing of the Group III nitride crystal film is preferably 3 nm or less. The thickness of the surface oxidized layer can be evaluated by ellipsometry, X-ray photoelectron spectroscopy (XPS), Auger electron spectroscopy (AES), Rutherford back-scattering spectroscopy (RBS), or the like. When the thickness of the surface oxidized layer after the polishing of the Group III nitride crystal film is 3 nm or less, an epitaxial layer having satisfactory morphology and crystallinity can be formed on the Group III nitride crystal film. From this viewpoint, the thickness of the surface oxidized layer is more preferably 2 nm or less.

Regarding the contents of impurities on the surface of the Group III nitride crystal film after the polishing, preferably, the content of atoms of elements each having an atomic number of 19 or more is $1 \times 10^{12}$ atoms/cm$^2$ or less and the content of atoms of elements each having an atomic number of 1 to 18 except for oxygen (O) and carbon (C) is $1 \times 10^{14}$ atoms/cm$^2$ or less. Each of the contents of O atom and C atom is preferably 40 atomic percent or less relative to the atoms of all elements that are present on the surface of the Group III nitride crystal film. Each of the contents of Group III element atoms and nitrogen (N) atom on the surface of the Group III nitride crystal film is preferably 40 to 60 atomic percent relative to the sum of the Group III element atoms and N atom that are present on the surface of the Group III nitride crystal film. The content of atoms of elements each having an atomic number of 19 or more and the content of atoms of elements each having an atomic number of 1 to 18 except for O and C can be evaluated by total reflection X-ray fluorescence spectroscopy (TXRF). The contents of O atom, C atom, N atom, and Group III element atoms can be evaluated by XPS, AES, or the like. When the surface of the Group III nitride crystal film has the above chemical composition, an epitaxial layer having satisfactory morphology and crystallinity can be formed on the Group III nitride crystal film.

In the method of surface treatment of a Group III nitride crystal film according to the present invention, the Group III nitride crystal film after the polishing is preferably subjected to thermal annealing. This thermal annealing can further decrease the surface roughness Ry and the surface roughness Ra of the Group III nitride crystal film after polishing. The thermal annealing is preferably performed at about 900°C to 1,100°C under a non-oxidizing atmosphere, more preferably, under a reducing atmosphere (specifically, under an $N_2$ gas atmosphere, an $NH_3$ gas atmosphere, a $H_2$ gas atmosphere, or the like).

A Group III nitride crystal substrate according to the present invention is a Group III nitride crystal substrate produced by the above-described method of surface treatment of a Group III nitride crystal film. The Group III nitride crystal substrate produced by the method of surface treatment has no affected layer or, if the substrate has an affected layer, the thickness of the affected layer is small. Accordingly, since the surface of the substrate is smoothed, an epitaxial layer having satisfactory morphology and crystallinity can be formed thereon. Specifically, the Group III nitride crystal substrate according to the present invention is produced by processing a Group III nitride crystal film grown by any one of various methods so as to form a peripheral shape according to need, slicing the film in a direction parallel to a predetermined plane, mechanically grinding or mechanically lapping the film by the above method, and polishing the surface of the film by the above method.

The method for growing the Group III nitride crystal film is not particularly limited. From the viewpoint that a large bulky Group III nitride crystal film is efficiently grown, a vapor phase growth method such as a halide or hydride vapor phase epitaxial growth (HVPE) method or a sublimation method, or a liquid phase growth method such as a flux method is preferably employed. For example, for the growth of a GaN crystal film, the HVPE method, the flux method, or the like is preferably employed and for the growth of an AlN crystal film, the HVPE method, the sublimation method, or the like is preferably employed.

The Group III nitride crystal substrate according to the present invention has a surface roughness Ry of 1 nm or less. Using the above method of surface treatment of a Group III nitride crystal film, a Group III nitride crystal substrate having an extremely flat surface with a surface roughness Ry of 1 nm or less, which has not been achieved hitherto, can be produced. An epitaxial layer having extremely satisfactory morphology can be formed on such a Group III nitride crystal substrate.

The Group III nitride crystal substrate according to the present invention has a surface roughness Ra of 0.1 nm or less. Using the above method of surface treatment of a Group III nitride crystal film, a Group III nitride crystal substrate having an extremely flat surface with a surface roughness Ra of 0.1 nm or less, which has not been achieved hitherto, can be produced. An epitaxial layer having extremely satisfactory morphology can be formed on such a Group III nitride crystal substrate.

A principal plane of the Group III nitride crystal substrate is preferably parallel to any plane of C-plane, A-plane, R-plane, M-plane, and S-plane in the wurtzite structure. Here, C-plane means {0001} plane and {000-1} plane, A-plane means {11-20} plane and an equivalent plane thereof, R-plane means {01-12} plane and an equivalent plane thereof, M-plane means {10-10} plane and an equivalent plane thereof, and S-plane means {10-11} plane and an equivalent plane thereof. When the principal plane of the Group III nitride crystal substrate is parallel or substantially parallel to any of the above planes in the wurtzite structure (for example, an off-angle formed by the principal plane of the Group III nitride crystal substrate and any plane of C-plane, A-plane, R-plane, M-plane, and S-plane in the wurtzite structure is less than 0.05°), an epitaxial layer having satisfactory morphology and crystallinity can be easily formed on the Group III nitride crystal substrate.

An off-angle formed by the principal plane of the Group III nitride crystal substrate and any plane of C-plane, A-plane, R-plane, M-plane, and S-plane in the wurtzite structure is preferably 0.05° to 15°. When an off-angle of 0.05° or more is provided, defect of an epitaxial layer formed on the Group III nitride crystal substrate can be decreased. However, when the off-angle exceeds 15°, a stair-like step is easily formed on the epitaxial layer. From this viewpoint, the off-angle is more preferably 0.1° to 10°.

A Group III nitride crystal substrate with an epitaxial layer according to the present invention includes at least one Group III nitride layer formed on the above Group III nitride crystal substrate by epitaxial growth. The above-described Group III nitride crystal substrate has no affected layer or, if the substrate has an affected layer, the thickness of the affected layer is small. Accordingly, since the surface of the substrate is planarized, the Group III nitride layer formed by epitaxial growth has satisfactory morphology. The Group III nitride layer is not particularly limited and an example thereof is a $Ga_xAl_yIn_{1-x-y}N$ layer ($0 \leq x$, $0 \leq y$, and $x + y \leq 1$). Also, a method for forming the Group III nitride layer by epitaxial growth is not particularly limited. Preferred examples thereof include an HVPE method, a molecular beam epitaxy (MBE) method, and a metalorganic chemical vapor deposition (MOCVD) method.

A semiconductor device according to the present invention includes the Group III nitride crystal substrate. The above Group III nitride crystal substrate has no affected layer or, if the substrate has an affected layer, the thickness of the affected layer is small. Accordingly, since the surface of the substrate is planarized, an epitaxial layer having satisfactory morphology and crystallinity is formed on this Group III nitride crystal substrate to form a semiconductor device with satisfactory quality. Examples of the semiconductor device of the present invention include light-emitting devices such as a light-emitting diode and a laser diode; electronic devices such as a rectifier, a bipolar transistor, a field-effect transistor, and high electron mobility transistor (HEMT); semiconductor sensors such as a temperature sensor, a pressure sensor, a radiation sensor, and a visible-ultraviolet light detector; and surface acoustic wave (SAW) devices.

Referring to Fig. 4, a semiconductor device according to the present invention is a semiconductor device 400 including a Group III nitride crystal substrate 410 described above. The semiconductor device 400 includes a light-emitting element and an electrical conductor 482. The light-emitting element includes the Group III nitride crystal substrate 410; a semiconductor layer 450 having at least three sublayers, the semiconductor layer 450 being formed on a principal plane of the Group III nitride crystal substrate 410 by epitaxial growth; a first electrode 461 formed on another principal plane of the Group III nitride crystal substrate 410; and a second electrode 462 formed on the outermost semiconductor sublayer of the semiconductor layer 450. In the light-emitting element, the face adjacent to the Group III nitride crystal substrate 410 serves as a light-emitting face and the face adjacent to the outermost semiconductor sublayer serves as a mounting face. The semiconductor layer 450 includes a p-type semiconductor sublayer 430, an n-type semiconductor sublayer 420, and a light-emitting sublayer 440 disposed between the p-type semiconductor sublayer 430 and the n-type semiconductor sublayer 420. This structure can provide a semiconductor device in which the face adjacent to the Group III nitride crystal substrate serves as a light-emitting face.

This semiconductor device is excellent in heat dissipation effect to heat generated at the light-emitting sublayer, compared with a semiconductor device in which the face adjacent to the semiconductor layer serves as the light-emitting face. Therefore, even when the semiconductor device operates at high electric power, an increase in the temperature of the semiconductor device can be suppressed, resulting in a light-emission with high luminance. Furthermore, an insulating substrate such as a sapphire substrate must have a single-sided electrode structure in which two types of electrodes, i.e., an n-side electrode and a p-side electrode are formed on the semiconductor layer. In contrast, the semiconductor device of the present invention can have a double-sided electrode structure in which electrodes are formed on both the semiconductor layer and the Group III nitride crystal substrate, and thus most part of the principal plane of the semiconductor device can be used as the light-emitting face. Furthermore, this structure is advantageous in that the production process can be simplified. For example, it is sufficient that the wire bonding is performed only once when the semiconductor device is mounted.

EXAMPLES

EXAMPLE 1

This example describes the case where a surface of a GaN crystal film grown by an HVPE method is mechanically lapped and then further polished. (1-1) Growth of GaN crystal film A GaN crystal film was grown by an HVPE method using a GaAs crystal substrate with a diameter of 50 mm as a base substrate. A boat containing metallic Ga was charged in a reacting furnace at atmospheric pressure and was heated to 800°C. A mixed gas of HCl gas and a carrier gas ($H_2$ gas) was introduced into the boat to generate GaCl gas and a mixed gas of $HN_3$ gas and a carrier gas ($H_2$ gas) was introduced into the reacting furnace, thereby allowing to react the GaCl gas and the $NH_3$ gas. Thus, a GaN crystal film having a thickness of 3 mm was grown on the base substrate (GaAs crystal substrate) disposed in the reacting furnace. In this step, the growth temperature of the GaN crystal film was 1,050°C, the partial pressure of the HCl gas in the reacting furnace was 2 kPa, and the partial pressure of the $NH_3$ gas was 30 kPa. (1-2) Mechanical lapping of surface of GaN crystal substrate

The GaN crystal film prepared by the above HVPE method was sliced in a plane direction parallel to the (0001) plane, which is a crystal growth plane, to prepare a GaN crystal substrate having a diameter of 50 mm and a thickness of 0.5 mm. Referring to Fig. 3, a C-plane ((000-1) plane) of the N plane-side of the GaN crystal substrate (Group III nitride crystal film 1) was bonded on a ceramic crystal holder 31 with wax. A surface plate 35 with a diameter of 300 mm was placed on a lapping machine (not shown). The surface plate 35 was rotated around a rotation axis 35c, while a slurry 37 prepared by dispersing diamond abrasive grains 36 was supplied from a slurry feed opening 39 on the surface plate 35. In addition, the GaN crystal substrate (Group III nitride crystal film 1) was rotated around a rotation axis 31c of the crystal holder 31, while being pressed on the surface plate 35 by placing a weight 34 on the crystal holder 31. Thereby, a surface of the GaN crystal substrate (a C-plane of the Ga plane-side, (0001) plane) was mechanically lapped. A copper surface plate or a tin surface plate was used as the surface plate 35. Three types of diamond abrasive grains that have a grain size of 6 $\mu$m, 3$\mu$m, and 1 $\mu$m were prepared. The abrasive grain size was decreased stepwise as the mechanical lapping proceeded. The lapping pressure was 100 to 500 g/cm$^2$. The rotational speeds of the GaN crystal substrate (Group III nitride crystal film 1) and the surface plate 35 were 30 to 100 rpm. This mechanical lapping provided the GaN crystal substrate with a mirror finished surface. After mechanical lapping, the thickness of the affected layer of the GaN crystal substrate was 380 nm, the surface roughness Ry was 10 nm, and the surface roughness Ra was 1 nm. (1-3) Polishing of surface of GaN crystal substrate

Referring to Fig. 1, the C-plane ((000-1) plane) of the N plane-side of the GaN crystal substrate (Group III nitride crystal film 1) after mechanical lapping was bonded on a ceramic crystal holder 11 with wax. A polishing pad 18 was placed on a surface plate 15 with a diameter of 300 mm disposed on a polishing machine (not shown). The polishing pad 18 was rotated around a rotation axis 15c, while a polishing liquid 17 prepared by dispersing abrasive grains 16 was supplied from a polishing liquid feed opening 19 on the polishing pad 18. In addition, the GaN crystal substrate (Group III nitride crystal film 1) was rotated around a rotation axis 11c of the crystal holder 11, while being pressed on the polishing pad 18 by placing a weight 14 on the crystal holder 11. Thus, the surface of the GaN crystal (the C-plane of the Ga plane-side, (0001) plane) was polished. In this step, an aqueous sodium carbonate solution containing colloidal silica ($SiO_2$) having a grain size of 0.1 $\mu$m and serving as abrasive grains 16, and sodium dichloroisocyanurate (hereinafter referred to as Na-DCIA) serving as an oxidizing agent was used as the polishing liquid 17. The pH of the polishing liquid 17 was adjusted to 9.5 and the oxidation-reduction potential was adjusted to 980 mV A polyurethane suede pad (Supreme RN-R, manufactured by Nitta Haas Incorporated.) was used as the polishing pad 18. A stainless steel surface plate was used as the surface plate 15. The polishing pressure was 200 to 1,000 g/cm$^2$. The rotational speeds of the GaN crystal substrate (Group III nitride crystal film 1) and the polishing pad 18 were 20 to 90 rpm. The polishing time was 60 minutes.

The polishing rate in this polishing was 0.4 $\mu$m/hr. After polishing, the thickness of the affected layer of the GaN crystal film was 8 nm, the surface roughness Ry of the GaN crystal film was 1.8 nm, and the surface roughness Ra was 0.15 nm. The thickness of the affected layer of the GaN crystal film was evaluated by observing a cross-section of the crystal film broken in a cleavage plane with a transmission electron microscope (TEM). The surface roughness Ry and the surface roughness Ra of the GaN crystal film were evaluated by observing a 10 $\mu$m square area of the GaN crystal substrate with an atomic force microscope (AFM). The affected layer refers to a layer in which crystal lattices are out of order, the layer being formed on the surface of a crystal film by grinding, lapping, or polishing of the surface of the crystal film. The presence and the thickness of the affected layer can be determined by a TEM observation. The thickness of the surface oxidized layer of the GaN crystal film after polishing was 1 nm. The contents of Ga atom and N atom on the surface of this GaN crystal film were 50 atomic percent and 50 atomic percent, respectively. The thickness of the surface oxidized layer and the contents of Ga atom and N atom were evaluated by XPS. (1-4) Thermal annealing of GaN crystal substrate

The GaN crystal substrate after polishing was placed in an MOCVD apparatus and was heated to 1,000°C while 1 slm (the term "slm" refers to a unit of a flow rate in which 1 L of a gas in normal state flows per minute, hereinafter the same) of $NH_3$ gas was supplied. The temperature was then kept at 1,000°C for 10 minutes while 0.5 to 5 slm of $NH_3$ gas was supplied, thereby performing thermal annealing of the GaN crystal substrate. (1-5) Formation of epitaxial layer on GaN crystal substrate

In the above MOCVD apparatus, trimethylgallium (TMG, hereinafter the same) gas was supplied on the GaN crystal substrate after thermal annealing at 1,000°C with a flow rate of 100 $\mu$mol/min for 60 minutes. Thus, a GaN layer having a thickness of 2 $\mu$m was formed on the GaN crystal substrate as an epitaxial layer. The surface of the epitaxial layer was a mirror finished surface having a surface roughness Ry of 1.4 nm and a surface roughness Ra of 0.12 nm. Table I summarizes the results.

COMPARATIVE EXAMPLE 1

A surface treatment of a GaN crystal substrate was performed and an epitaxial layer was formed as in Example 1 except that an aqueous solution containing colloidal silica ($SiO_2$) having a grain size of 0.1 $\mu$m and serving as the abrasive grains 16 wherein the pH was adjusted to 7.3 and the oxidation-reduction potential was adjusted to 450 mV was used as the polishing liquid 17. The polishing rate was 0 $\mu$m/hr, and thus the polishing did not proceed. After polishing, the thickness of the affected layer of the GaN crystal film was 380 nm. The surface roughness Ry of the GaN crystal film after polishing was 12 nm, and the surface roughness Ra was 0.91 nm. The epitaxial layer formed on the GaN crystal substrate was clouded. The surface roughness Ry of the epitaxial layer exceeded 100 nm and the surface roughness Ra exceeded 10 nm. Table I summarizes the results.

COMPARATIVE EXAMPLE 2

A surface treatment of a GaN crystal substrate was performed and an epitaxial layer was formed as in Example 1 except that an aqueous sodium carbonate solution containing colloidal silica ($SiO_2$) having a grain size of 0.1 $\mu$m and serving as the abrasive grains 16 wherein the pH was adjusted to 8.9 and the oxidation-reduction potential was adjusted to 460 mV was used as the polishing liquid 17. The polishing rate was 0 $\mu$m/hr, and thus the polishing did not proceed. After polishing, the thickness of the affected layer of the GaN crystal film was 380 nm. The surface roughness Ry of the GaN crystal film after polishing was 8.4 nm, and the surface roughness Ra was 0.71 nm. The epitaxial layer formed on the GaN crystal substrate was clouded. The surface roughness Ry of the epitaxial layer exceeded 100 nm and the surface roughness Ra exceeded 10 nm. Table I summarizes the results.

EXAMPLE 2

A surface treatment of a GaN crystal substrate was performed and an epitaxial layer was formed as in Example 1 except that an aqueous nitric acid solution containing colloidal silica ($SiO_2$) having a grain size of 0.1 $\mu$m and serving

as the abrasive grains 16 and trichloroisocyanuric acid (hereinafter referred to as TCIA) serving as an oxidizing agent wherein the pH was adjusted to 2.4 and the oxidation-reduction potential was adjusted to 1,420 mV was used as the polishing liquid 17. Table I summarizes the results.

EXAMPLES 3 to 5

A surface treatment of a GaN crystal substrate was performed and an epitaxial layer was formed as in Example 1 except that an aqueous nitric acid solution containing $Al_2O_3$ particles serving as the abrasive grains 16 and TCIA serving as an oxidizing agent wherein the pH was adjusted to 3.5 and the oxidation-reduction potential was adjusted to 1,200 mV was used as the polishing liquid 17. The abrasive grains 16 having a grain size of 0.5 $\mu$m (Example 3), 1.0 $\mu$m (Example 4), or 2.0 $\mu$m (Example 5) were used. Table I summarizes the results.

EXAMPLE 6

A surface treatment of a GaN crystal substrate was performed and an epitaxial layer was formed as in Example 1 except that an aqueous tartaric acid solution containing $Al_2O_3$ particles (high-hardness abrasive grains) and colloidal silica ($SiO_2$) (low-hardness abrasive grains), both of which serve as the abrasive grains 16, in a ratio of $Al_2O_3$:$SiO_2$ = 10:90 and TCIA serving as an oxidizing agent wherein the pH was adjusted to 3.5 and the oxidation-reduction potential was adjusted to 1,200 mV was used as the polishing liquid 17. The $Al_2O_3$ abrasive grains used had a grain size of 0.5 $\mu$m and the $SiO_2$ abrasive grains used had a grain size of 0.1 $\mu$m. Table I summarizes the results.

COMPARATIVE EXAMPLE 3

A GaN crystal substrate was mechanically lapped as in Example 1. Subsequently, instead of polishing, a dry etching was performed with a parallel plate type reactive ion etching (RIE) apparatus. The dry etching was performed for 15 minutes using a mixed gas containing $Cl_2$ gas and Ar gas ($Cl_2$ gas flow rate: 25 sccm, Ar gas flow rate: 25 sccm (the term "sccm" refers to a unit of a flow rate in which 1 $cm^3$ of a gas in normal state flows per minute, hereinafter the same)) as an etching gas, at a pressure of 3.99 Pa (30 mTorr), and with a power of 200 W. Table I summarizes the results.

Table I

| | Example 1 | Example 2 | Example 3 | Example 4 | Example 5 | Example 6 | Comparative example 1 | Comparative example 2 | Comparative example 3 |
|---|---|---|---|---|---|---|---|---|---|
| Crystal composition | GaN | GaN | GaN | GaN | GaN | GaN | GaN | GaN | GaN |
| Crystal growth method | HVPE method | HVPE method | HVPE method | HVPE method | HVPE method | HVPE method | HVPE method | HVPE method | HVPE method |
| Mechanical grinding or mechanical lapping | Mechanical lapping | Mechanical lapping | Mechanical lapping | Mechanical lapping | Mechanical lapping | Mechanical lapping | Mechanical lapping | Mechanical lapping | Mechanical lapping |

| | | Example 1 | Example 2 | Example 3 | Example 4 | Example 5 | Example 6 | Comparative example 1 | Comparative example 2 | Comparative example 3 |
|---|---|---|---|---|---|---|---|---|---|---|
| Polishing | PH of polishing liquid | 9.5 | 2.4 | 3.5 | 3.5 | 3.5 | 3.5 | 7.3 | 8.9 | Dry etching (RIE method) |
| | Oxidation-reduction potential of polishing liquid (mV) | 980 | 1,420 | 1,200 | 1,200 | 1,200 | 1,200 | 450 | 460 | |
| | Oxidizing agent | Na-DCIA | TCIA | TCIA | TCIA | TCIA | TCIA | - | - | |
| | High-hardness abrasive grain | - | - | $Al_2O_3$ | $Al_2O_3$ | $Al_2O_3$ | $Al_2O_3$ | - | - | |
| | Grain size ($\mu$m) | - | - | 0.5 | 1.0 | 2.0 | 0.5 | - | - | |
| | Low-hardness abrasive grain | $SiO_2$ | $SiO_2$ | - | - | - | $SiO_2$ | $SiO_2$ | $SiO_2$ | |
| | Mixing volume ratio(high-hardness abrasive grain:low-hardness abrasive grain | - | - | - | - | - | 10:90 | - | - | |
| | Polishing rate ($\mu$m/hr) | 0.4 | 0.5 | 1.1 | 1.6 | 1.9 | 0.8 | 0 | 0 | 6 |

EP 2 039 733 A1

(continued)

| | | Example 1 | Example 2 | Example 3 | Example 4 | Example 5 | Example 6 | Comparative example 1 | Comparative example 2 | Comparative example 3 |
|---|---|---|---|---|---|---|---|---|---|---|
| After polishing | Affected layer (nm) | 8 | 12 | 31 | 50 | 89 | 15 | 380 | 380 | 15 |
| | Surface roughness Ry (nm) | 1.8 | 1.0 | 4.1 | 5.3 | 8.9 | 2.9 | 12.0 | 8.4 | 20 |
| | Surface roughness Ra (nm) | 0.15 | 0.09 | 0.42 | 0.51 | 0.85 | 0.26 | 0.91 | 0.71 | 1.9 |
| Epitaxi al layer | Surface roughness Ry (nm) | 1.4 | 0.9 | 3.4 | 4.2 | 7.0 | 2.4 | >100 | >100 | 16 |
| | Surface roughness Ra (nm) | 0.12 | 0.08 | 0.35 | 0.4 | 0.67 | 0.23 | >10 | >10 | 1.4 |
| Note) Na-DCIA: sodium dichloroisocyanurate, TCIA: trichloroisocyanuric acid | | | | | | | | | | |

As is apparent from Table I, by polishing using a polishing liquid wherein a pH value x and an oxidation-reduction potential value y (mV) of the polishing liquid satisfy both relationships of y ≥ -50x + 1,000 (Ex. (1)) and y ≤ - 50x + 1,900 (Ex. (2)), a satisfactory quality smooth surface of a GaN crystal film with a thin affected layer, and an epitaxial layer having satisfactory morphology and crystal quality were obtained.

When low-hardness abrasive grains ($SiO_2$) were used as the abrasive grains contained in the polishing liquid, the thickness of the affected layer could be reduced. When high-hardness abrasive grains ($Al_2O_3$) were used, the polishing rate could be increased. Furthermore, by using high-hardness abrasive grains having a grain size of 1.0 μm or less, the thickness of the affected layer could be reduced to 50 nm or less. By using mixed abrasive grains containing high-hardness abrasive grains and low-hardness abrasive grains, the thickness of the affected layer could be reduced while a high polishing rate was maintained.

On the other hand, in the dry etching such as RIE, although the affected layer could be removed in a short time, the morphology of the surface of the GaN crystal film was degraded (the surface roughness Ry and the surface roughness Ra of the GaN crystal film were increased), and the morphology of the surface of the epitaxial layer was also degraded (the surface roughness Ry and the surface roughness Ra of the epitaxial layer were also increased).

EXAMPLES 7 to 10

Examples 7 to 10 describe the cases where a surface of a GaN crystal film grown by a flux method is mechanically lapped and then further polished. (2-1) Growth of GaN crystal film

A GaN crystal film was grown by a flux method using a GaN crystal substrate with a diameter of 50 mm prepared by the HVPE method as a base substrate. Metallic Ga serving as a Ga raw material and metallic Na serving as a flux were charged in a crucible so that the ratio of Ga:Na was 1:1 by molar ratio, and heated to prepare a Ga-Na melt at 800°C. Nitrogen gas serving as an N raw material at 5 MPa was dissolved in the Ga-Na melt to grow a GaN crystal film having a thickness of 0.6 mm. Thus, GaN crystal films were prepared in the same manner. (2-2) Mechanical lapping of surface of GaN crystal substrate

Each of the GaN crystal films prepared by the flux method was processed by cutting or the like, so that a plane parallel to the (0001) plane, which is a crystal growth plane, served as a surface. Thus, a GaN crystal substrate having a diameter of 50 mm and a thickness of 0.4 mm was prepared. The mechanical lapping of the GaN crystal substrate was performed as in Example 1. (2-3) Polishing of surface of GaN crystal substrate

The surface of each GaN crystal substrate after mechanical lapping was polished as in Example 1 except that the pH and the oxidation-reduction potential of a polishing liquid, an oxidizing agent added to the polishing liquid, high-hardness abrasive grains, and low-hardness abrasive grains were changed as shown in Table II. (2-4) Thermal annealing of GaN crystal substrate Each of the GaN crystal substrates after polishing was placed in an MOCVD apparatus, and thermal annealing of the GaN crystal substrate was performed as in Example 1. (2-5) Formation of epitaxial layer on GaN crystal substrate

In the MOCVD apparatus, a GaN layer having a thickness of 2 μm was formed on each GaN crystal substrate as an epitaxial layer as in Example 1. Table II summarizes the results.

Table II

| | | Example 7 | Example 8 | Example 9 | Example 10 |
|---|---|---|---|---|---|
| Crystal composition | | GaN | GaN | GaN | GaN |
| Crystal growth method | | Flux method | Flux method | Flux method | Flux method |
| Mechanical grinding or mechanical lapping | | Mechanical lapping | Mechanical lapping | Mechanical lapping | Mechanical lapping |
| Polishing | PH of polishing liquid | 2.0 | 4.0 | 8.0 | 10.0 |
| | Oxidation reduction potential of polishing liquid (mV) | 1,440 | 1,350 | 1,110 | 960 |
| | Oxidizing agent | TCIA | TCIA | TCIA | TCIA |
| | High-hardness abrasive grain | $Cr_2O_3$ | $Cr_2O_3$ | $Cr_2O_3$ | $Cr_2O_3$ |
| | Grain size ($\mu$m) | 0.8 | 0.8 | 0.8 | 0.8 |
| | Low-hardness abrasive grain | $SiO_2$ | $SiO_2$ | $SiO_2$ | $SiO_2$ |
| | Mixing volume ratio(high hardness abrasive grain: low hardness abrasive grain | 10:90 | 10:90 | 10:90 | 10:90 |
| | Polishing rate ($\mu$m/hr) | 1.1 | 0.9 | 0.6 | 0.8 |
| After polishing | Affected layer (nm) | 42 | 38 | 35 | 39 |
| | Surface roughness Ry (nm) | 6.4 | 6.2 | 5.9 | 5.7 |
| | Surface roughness Ra (nm) | 0.63 | 0.60 | 0.61 | 0.55 |
| Epitaxial layer | Surface roughness Ry (nm) | 5.1 | 5.0 | 4.7 | 4.6 |
| | Surface roughness Ra (nm) | 0.51 | 0.49 | 0.49 | 0.46 |
| Note) TCIA: trichloroisocyanuric acid | | | | | |

As is apparent from Table II, by using a polishing liquid having a pH of up to 4 or at least 10, the polishing rate could be increased by 1.3 times or more, compared with a polishing liquid having a pH of 8. Furthermore, by using a polishing liquid having a pH of up to 2, the polishing rate could be increased by 1.8 times or more

EXAMPLES 11 to 17

Examples 11 to 17 describe the cases where a surface of a GaN crystal film grown by an HVPE method is mechanically ground and then further polished. (3-1) Growth of GaN crystal film

First, GaN crystal films were grown by an HVPE method as in Example 1. (3-2) Mechanical grinding of surface of GaN crystal substrate

Each of the GaN crystal films prepared by the HVPE method was sliced in a plane direction parallel to the (0001) plane, which is a crystal growth plane, to prepare a GaN crystal substrate having a diameter of 50 mm and a thickness of 0.6 mm. Referring to Fig. 2, a C-plane ((000-1) plane) of the N plane-side of the GaN crystal substrate (Group III nitride crystal film 1) was bonded on a ceramic crystal holder 21 with wax. An infeed grinding machine was used. A ring-shaped vitrified bonded diamond grinding wheel (80 mm in outer diameter and 5 mm in width) was used as a grinding wheel 22. The GaN crystal substrate (Group III nitride crystal film 1) was fixed to a crystal holder 21 and was rotated around a rotation axis 21c. In addition, the grinding wheel 22 was moved to the surface of the GaN crystal film, while the grinding wheel 22 fixed to a grinding wheel base 23 was rotated around a rotation axis 23c. Thereby, a surface of the GaN crystal substrate (a C-plane of the Ga plane-side, (0001) plane) was mechanically ground. Four types of diamond grinding wheels that have a grain size of 15 $\mu$m, 5 $\mu$m, 3$\mu$m, and 1 $\mu$m were prepared. The abrasive grain size was decreased stepwise as the mechanical grinding proceeded. This mechanical grinding provided the GaN crystal substrate with a mirror finished surface. (3-3) Polishing of surface of GaN crystal substrate

The surface of each GaN crystal substrate after mechanical grinding was polished as in Example 1 except that the pH and the oxidation-reduction potential of a polishing liquid, an oxidizing agent added to the polishing liquid, high-hardness abrasive grains, and low-hardness abrasive grains were changed as shown in Table III. The order of the hardness of the high-hardness abrasive grains was $SiC > Al_2O_3 > Cr_2O_3 > ZrO_2$. (3-4) Thermal annealing of GaN crystal substrate

Each of the GaN crystal substrate after polishing was placed in an MOCVD apparatus, and thermal annealing of the GaN crystal substrate was performed as in Example 1. (3-5) Formation of epitaxial layer on GaN crystal substrate

In the MOCVD apparatus, a GaN layer having a thickness of 2 $\mu$m was formed on each GaN crystal substrate as an epitaxial layer as in Example 1. Table III summarizes the results.

Table III

| | | Example 11 | Example 12 | Example 13 | Example 14 | Example 15 | Example 16 | Example 17 |
|---|---|---|---|---|---|---|---|---|
| Crystal composition | | GaN | GaN | GaN | GaN | GaN | GaN | GaN |
| Crystal growth method | | HVPE method | HVPE method | HVPE method | HVPE method | HVPE method | HVPE method | HVPE method |
| Mechanical grinding or mechanical lapping | | Mechanical grinding | Mechanical grinding | Mechanical grinding | Mechanical grinding | Mechanical grinding | Mechanical grinding | Mechanical grinding |
| Polishing | PH of polishing liquid | 3.5 | 3.5 | 3.5 | 3.5 | 3.5 | 3.5 | 3.5 |
| | Oxidation-reduction potential of polishing liquid (mV) | 1,200 | 1,200 | 1,200 | 1,200 | 1,200 | 1,200 | 1,200 |
| | Oxidizing agent | NaClO | NaClO | NaClO | NaClO | NaClO | NaClO | NaClO |
| | High-hardness abrasive grain | $Cr_2O_3$ | SiC | SiC | $Al_2O_3$ | $Al_2O_3$ | $Cr_2O_3$ | $ZrO_2$ |
| | Grain size ($\mu$m) | 0.8 | 1.0 | 0.5 | 0.5 | 0.2 | 0.3 | 0.5 |
| | Low-hardness abrasive grain | $SiO_2$ | $SiO_2$ | $CeO_2$ | $MnO_2$ | $Fe_2O_8$ | $Fe_2O_3$ | $TiO_2$ |
| | Mixing volume ratio(high-hardness abrasive grain: low- hardness abrasive grain | 10:90 | 10:90 | 10:90 | 10:90 | 20:80 | 10:90 | 30:70 |
| | Polishing rate ($\mu$m/hr) | 0.8 | 1.0 | 0.7 | 0.7 | 0.4 | 0.5 | 0.4 |

EP 2 039 733 A1

17

| | | Example 11 | Example 12 | Example 13 | Example 14 | Example 15 | Example 16 | Example 17 |
|---|---|---|---|---|---|---|---|---|
| After polishing | Affected layer (nm) | 42 | 60 | 32 | 18 | 15 | 16 | 11 |
| | Surface roughness Ry (nm) | 6.3 | 9.8 | 4.8 | 3.3 | 2.3 | 3.1 | 1.8 |
| | Surface roughness Ra (nm) | 0.60 | 1.1 | 0.45 | 0.33 | 0.23 | 0.31 | 0.15 |
| Epitaxial layer | Surface roughness Ry (nm) | 4.9 | 7.6 | 3.9 | 2.8 | 2.0 | 2.5 | 1.5 |
| | Surface roughness Ra (nm) | 0.50 | 0.89 | 0.38 | 0.27 | 0.18 | 0.24 | 0.13 |
| Note) NaClO: sodium hypochlorite | | | | | | | | |

As is apparent from Table III, polishing using a polishing liquid containing a mixture of various high-hardness abrasive grains and low-hardness abrasive grains could also achieve a surface treatment that provided a satisfactory morphology of the surface of a GaN crystal film with high polishing rate. In these examples, as the hardness of high-hardness abrasive grains decreased or as the grain size of high-hardness abrasive grains decreased, the thickness of the affected layer of the GaN crystal film, the surface roughness Ry, and the surface roughness Ra also decreased, thus improving the surface quality of the GaN crystal substrate. The improvement in the morphology of the surface of the GaN crystal substrate also improved the morphology of the epitaxial layer formed on the GaN crystal substrate.

EXAMPLES 18 to 23

In Examples 18 to 23, GaN crystal films grown by an HVPE method (4-1) were sliced in various plane directions to prepare GaN crystal substrates. Subsequently, each of the GaN crystal substrates was mechanically lapped as in Example 1 (4-2), and further polished under the conditions shown in Table IV. Table IV summarizes the results.

Table IV

|  | Example 18 | Example 19 | Example 20 | Example 21 | Example 22 | Example 23 |
|---|---|---|---|---|---|---|
| Crystal composition | GaN | GaN | GaN | GaN | GaN | GaN |
| Crystal growth method | HVPE method | HVPE method | HVPE method | HVPE method | HVPE method | HVPE method |
| Name of plane | C-plane (Ga planeside) | R-plane | S-plane | M-plane | A-plane | C-plane (n plane side) |
|  | (0001) | (1-120) | (11-10) | (1-100) | (11-20) | (000-1) |
| Mechanical grinding or mechanical lapping | Mechanical lapping | Mechanical lapping | Mechanical lapping | Mechanical lapping | Mechanical lapping | Mechanical lapping |

(continued)

| | | Example 18 | Example 19 | Example 20 | Example 21 | Example 22 | Example 23 |
|---|---|---|---|---|---|---|---|
| Polishing After polishing | PH of polishing liquid | 2.4 | 2.4 | 2.4 | 2.4 | 2.4 | 2.4 |
| | Oxidation-reduction potential of polishing liquid (mV) Oxidizing agent High-hardness abrasive grain Grain size ($\mu$m) Low-hardness abrasive grain Mixing volume ratio(high hardness abrasive grain:low-hardness abrasive grain | 1,410 | 1,410 | 1,410 | 1,410 | 1,410 | 1,410 |
| | | $KMnO_4$ | $KMnO_4$ | $KMnO_4$ | $KMnO_4$ | $KMnO_4$ | $KMnO_4$ |
| | | $Al_2O_3$ | $Al_2O_3$ | $Al_2O_3$ | $Al_2O_3$ | $Al_2O_3$ | $Al_2O_3$ |
| | | 0.5 | 0.5 | 0.5 | 0.5 | 0.5 | 0.5 |
| | | $SiO_2$ | $SiO_2$ | $SiO_2$ | $SiO_2$ | $SiO_2$ | $SiO_2$ |
| | | 20:80 | 20:80 | 20:80 | 20:80 | 20:80 | 20:80 |
| | Polishing rate ($\mu$m/hr) Affected layer (nm) Surface roughness Ry (nm) Surface roughness Ra (nm) | 0.8 | 1.3 | 1.5 | 1.7 | 1.8 | 2.3 |
| | | 22 | 22 | 23 | 24 | 25 | 25 |
| | | 3.5 | 3.7 | 3.7 | 3.6 | 3.8 | 3.4 |
| | | 0.33 | 0.34 | 0.35 | 0.33 | 0.35 | 0.33 |

Note) $KMnO_4$: potassium permanganate

As is apparent from Table IV, by the polishing of the present invention, a surface treatment that provided a satisfactory quality of the surface of a GaN crystal film with high polishing rate could be performed in any principal plane of the GaN crystal substrate, i.e., C-plane, A-plane, R-plane, M-plane, and S-plane. As is apparent from Table IV, the order of the plane having higher polishing rate was C plane (N plane-side) > A-plane > M-plane > S-plane > R-plane > C plane (Ga plane-side).

EXAMPLES 24 to 30

Examples 24 to 30 describe the cases where a surface of an AlN crystal film grown by a sublimation method is mechanically lapped and then further polished. (5-1) Growth ofAlN crystal film
An AlN crystal film was grown by a sublimation method on a C-plane ((0001) plane) of the A1 plane-side of an AlN seed crystal (50 mm in diameter x 1.5 mm in thickness) as follows.
First, an AlN raw material such as an AlN powder was placed at the bottom of a BN crucible and an AlN seed crystal was disposed at the upper part of the crucible with an inner diameter of 50 mm. The temperature in the crucible was then increased while $N_2$ gas was supplied around the crucible. During the increase in the inner temperature of the crucible, the temperature of the crucible adjacent to the AlN seed crystal was controlled to be higher than that of the crucible adjacent to the AlN raw material. Thus, the surface of the AlN seed crystal was cleaned by etching during the increase in temperature, and impurities that were emitted from the AlN seed crystal and the inside of the crucible during the increase in temperature were removed through an outlet provided on the crucible.

Subsequently, the temperature of the crucible adjacent to the AlN seed crystal was controlled to 2,100°C and that of the crucible adjacent to the AlN raw material was controlled to 2,150°C so as to sublime AlN from the AlN raw material. The sublimed AlN was solidified again on the AlN seed crystal disposed on the upper part of the crucible, thus growing an AlN crystal film. During the growth of the AlN crystal film, $N_2$ gas was continued to flow around the crucible and the flow rate of the $N_2$ gas was controlled such that the partial pressure of the gas around the crucible was about 101.3 to 1,013 hPa. The AlN crystal film was grown for 50 hours under the above crystal growth condition. Thus, AlN crystal films were prepared in the same manner. (5-2) Mechanical lapping of surface of AlN crystal substrate

Each of the AlN crystal films prepared by the sublimation method was sliced in a plane direction parallel to the (0001) plane of the AlN seed crystal, which is a crystal growth plane, to prepare an AlN crystal substrate having a diameter of 50 mm and a thickness of 0.6 mm. The mechanical lapping of the AlN crystal substrate was performed as in Example 1. (5-3) Polishing of surface of AlN crystal substrate

The surface of each AlN crystal substrate after mechanical lapping was polished as in Example 1 except that the pH and the oxidation-reduction potential of a polishing liquid, an oxidizing agent added to the polishing liquid, high-hardness abrasive grains, and low-hardness abrasive grains were changed as shown in Table V (5-4) Thermal annealing of AlN crystal substrate

Each of the AlN crystal substrates after polishing was placed in an MOCVD apparatus, and thermal annealing of the AlN crystal substrate was performed as in Example 1. (5-5) Formation of epitaxial layer on AlN crystal substrate

In the above MOCVD apparatus, TMG gas was supplied on each of the AlN crystal substrates after thermal annealing at 1,000°C with a flow rate of 2 slm for 60 minutes. Thus, a GaN layer having a thickness of 2 $\mu$m was formed on each AlN crystal substrate as an epitaxial layer. Table V summarizes the results.

Table V

| | | Example 24 | Example 25 | Example 26 | Example 27 | Example 28 | Example 29 | Example 30 |
|---|---|---|---|---|---|---|---|---|
| Crystal composition | | AlN | AlN | AlN | AlN | AlN | AlN | AlN |
| Crystal growth method | | Sublimation method | Sublimation method | Sublimation method | Sublimation method | Sublimation method | Sublimation method | Sublimation method |
| Mechanical grinding or mechanical lapping | | Mechanical lapping | Mechanical lapping | Mechanical lapping | Mechanical lapping | Mechanical lapping | Mechanical lapping | Mechanical lapping |
| Polishing | PH of polishing liquid | 9.5 | 2.4 | 3.5 | 3.5 | 3.5 | 3.5 | 3.5 |
| | Oxidation-reduction potential of polishing liquid (mV) | 980 | 1,420 | 1,200 | 1,200 | 1,200 | 1,200 | 1,200 |
| | Oxidizing agent | Na-DCIA | TCIA | TCIA | TCIA | TCIA | TCIA | TCIA |
| | High-hardness abrasive grain | | | $Al_2O_3$ | $Al_2O_3$ | $Al_2O_3$ | $Al_2O_3$ | $Cr_2O_3$ |
| | Grain size ($\mu$m) | | | 0.5 | 1.0 | 2.0 | 0.5 | 0.8 |
| | Low-hardness abrasive grain | $SiO_2$ | $SiO_2$ | | | | $SiO_2$ | $SiO_2$ |
| | Mixing volume ratio(high hardness abrasive grain: low-hardness abrasive grain | | | | | | 10:90 | 10:90 |
| | Polishing rate ($\mu$m/hr) | 0.6 | 0.8 | 1.4 | 2.3 | 2.8 | 1.2 | 1.6 |

(continued)

| | | Example 24 | Example 25 | Example 26 | Example 27 | Example 28 | Example 29 | Example 30 |
|---|---|---|---|---|---|---|---|---|
| After polishing | Affected layer (nm) | 8 | 11 | 28 | 48 | 89 | 14 | 24 |
| | Surface roughness Ry (nm) | 1.0 | 1.4 | 4.5 | 5.7 | 8.2 | 3.1 | 4.0 |
| | Surface roughness Ra (nm) | 0.09 | 0.12 | 0.41 | 0.52 | 0.78 | 0.28 | 0.38 |
| Epitaxial layer | Surface roughness Ry (nm) | 0.9 | 1.2 | 3.7 | 4.4 | 6.3 | 2.5 | 3.2 |
| | Surface roughness Ra (nm) | 0.07 | 0.10 | 0.34 | 0.41 | 0.61 | 0.23 | 0.32 |
| Note) Na-DCIA: sodium dichloroisocyanurate, TCIA: trichloroisocyanuric acid | | | | | | | | |

As is apparent from Table V, by polishing using a polishing liquid
wherein a pH value x and an oxidation-reduction potential value y (mV) of the polishing liquid satisfy both relationships of $y \geq -50x + 1{,}000$ (Ex. (1)) and $y \leq -50x + 1{,}900$ (Ex. (2)), a satisfactory quality smooth surface of an AlN crystal film with a thin affected layer, and an epitaxial layer having satisfactory morphology and crystal quality were obtained.

EXAMPLE 31

An n-type GaN crystal film was prepared by doping Si into a GaN crystal during the growth of a GaN crystal film by an HVPE method. The prepared n-type GaN crystal film was mechanically lapped as in Example 1 and then polished as in Example 6 to prepare an n-type GaN crystal substrate.

Subsequently, referring to Fig. 4, on a principal plane of the n-type GaN crystal substrate (Group III nitride crystal substrate 410), an n-type GaN sublayer 421 (dopant: Si) with a thickness of 1 $\mu$m and an n-type $Al_{0.1}Ga_{0.9}N$ sublayer 422 (dopant: Si) with a thickness of 150 nm, both of which serve as an n-type semiconductor sublayer 420, a light-emitting sublayer 440, and a p-type $Al_{0.2}Ga_{0.8}N$ sublayer 431 (dopant: Mg) with a thickness of 20 nm and a p-type GaN sublayer 432 (dopant: Mg) with a thickness of 150 nm, both of which serve as a p-type semiconductor sublayer 430 were sequentially formed by an MOCVD method. Thus, a light-emitting element serving as a semiconductor device was prepared. The light-emitting sublayer 440 had a multiple-quantum-well structure in which four barrier sublayers each composed of a GaN layer with a thickness of 10 nm and three well layers each composed of a $Ga_{0.85}In_{0.15}N$ layer with a thickness of 3 nm were alternately laminated.

Subsequently, on another principal plane of the n-type GaN crystal substrate, a laminated structure including a Ti layer with a thickness of 200 nm, an Al layer with a thickness of 1,000 nm, a Ti layer with a thickness of 200 nm, and an Au layer with a thickness of 2,000 nm was formed as a first electrode 461. The first electrode 461 was heated in a nitrogen atmosphere to form an n-side electrode with a diameter of 100 $\mu$m. On the other hand, on the p-type GaN sublayer 432, a laminated structure including a Ni layer with a thickness of 4 nm and an Au layer with a thickness of 4 nm was formed as a second electrode 462. The second electrode 462 was heated in an inert gas atmosphere to form a p-side electrode. The resulting laminate was cut into a chip with a dimension of 400 $\mu$m square and the p-side electrode was bonded on an electrical conductor 482 with a solder layer 470 composed of AuSn. Furthermore, the n-side electrode was bonded to an electrical conductor 481 with a wire 490. Thus, a semiconductor device 400 serving as a light-emitting device was obtained.

Thus, a light-emitting device is obtained in which the face adjacent to the GaN crystal substrate (Group III nitride crystal substrate 410) serves as a light-emitting face and the face adjacent to the p-type GaN sublayer 432, which is the outermost semiconductor sublayer of the semiconductor layer 450, serves as a face mounted on the electrical conductor 482. Additionally, an emission spectrum of this light-emitting device measured with a spectrometer had a peak wavelength at 450 nm.

It should be understood that the embodiments and the examples disclosed herein are all illustrative and not restrictive. The scope of the present invention is defined by the appended claims rather than by the description preceding them, and equivalence of meanings of the claims and all changes that fall within such meanings are intended to be embraced by the claims.

Further embodiments enclose:

Embodiment 1

A method of surface treatment of a Group III nitride crystal film comprising: polishing a surface of the Group III nitride crystal film, wherein a pH value x and an oxidation-reduction potential value y (mV) of a polishing liquid used for the polishing satisfy both relationships represented by Ex. (1) and Ex. (2):

$$y \geq -50x + 1{,}000 \dots (1)$$

$$y \leq -50x + 1{,}900 \dots (2)$$

The method of surface treatment of a Group III nitride crystal film according to embodiment 1, wherein the pH of the polishing liquid is up to 6 or at least 8.

The method of surface treatment of a Group III nitride crystal film according to embodiment 1, wherein the polishing liquid comprises abrasive grains and the abrasive grains are high-hardness abrasive grains having a hardness higher than that of the Group III nitride crystal film, low-hardness abrasive grains having a hardness lower than or equal to that of the Group III nitride crystal film, or mixed abrasive grains containing the high-hardness abrasive grains and the low-hardness abrasive grains.

The method of surface treatment of a Group III nitride crystal film according to embodiment 1, wherein the grain size of the high-hardness abrasive grains is 1 μm or less.

The method of surface treatment of a Group III nitride crystal film according to embodiment 1, wherein the high-hardness abrasive grains comprise at least one material selected from the group consisting of diamond, SiC, $Si_3N_4$, BN, $Al_2O_3$, $Cr_2O_3$, and $ZrO_2$.

The method of surface treatment of a Group III nitride crystal film according to any one of embodiment 1, wherein the low-hardness abrasive grains comprise at least one material selected from the group consisting of $SiO_2$, $CeO_2$, $TiO_2$, MgO, $MnO_2$, $Fe_2O_3$, $Fe_3O_4$ NiO, ZnO, CoO, $Co_3O_4$, $SnO_2$, CuO, $Cu_2O$, $GeO_2$, CaO, $Ga_2O_3$, and $In_2O_3$.

The method of surface treatment of a Group III nitride crystal film according to any one of embodiment 1, wherein a surface of the Group III nitride crystal film is mechanically ground or mechanically lapped and the mechanically ground or mechanically lapped surface of the Group III nitride crystal film is then polished.

The method of surface treatment of a Group III nitride crystal film according to any one of embodiment 1, wherein the thickness of an affected layer after the polishing of the Group III nitride crystal film is 50 nm or less.

The method of surface treatment of a Group III nitride crystal film according to any one of embodiment 1, wherein the surface roughness Ry after the polishing of the Group III nitride crystal film is 5 nm or less.

The method of surface treatment of a Group III nitride crystal film according to any one of embodiment 1, wherein the surface roughness Ra after the polishing of the Group III nitride crystal film is 0.5 nm or less.

The method of surface treatment of a Group III nitride crystal film according to any one of embodiment 1, wherein the Group III nitride crystal film after the polishing is subjected to thermal annealing.

A Group III nitride crystal substrate prepared by the method of surface treatment of a Group III nitride crystal film according to any one of embodiment 1.

The Group III nitride crystal substrate according to any one of embodiment 1, wherein a principal plane of the Group III nitride crystal substrate is parallel to any plane of C-plane, A-plane, R-plane, M-plane, and S-plane in the wurtzite structure.

The Group III nitride crystal substrate according to any one of embodiment 1, wherein an off-angle formed by a principal plane of the Group III nitride crystal substrate and any plane of C-plane, A-plane, R-plane, M-plane, and S-plane in the wurtzite structure is 0.05° to 15°.

A Group III nitride crystal substrate with an epitaxial layer, comprising: the Group III nitride crystal substrate according to any one of embodiment 1, and at least one Group III nitride layer formed on the Group III nitride crystal substrate by epitaxial growth.

A semiconductor device comprising the Group III nitride crystal substrate according to any one of embodiment 1.

The semiconductor device according to embodiment 1, further comprising: a light-emitting element including a semiconductor layer composed of three or more sublayers formed on a principal plane of the Group III nitride crystal substrate by epitaxial growth, a first electrode formed on another principal plane of the Group III nitride crystal substrate, and a second electrode formed on the outermost semiconductor sublayer of the semiconductor layer; and an electrical conductor mounting the light-emitting element, wherein, in the light-emitting element, the face adjacent to the Group III nitride crystal substrate serves as a light-emitting face and the face adjacent to the outermost semiconductor sublayer serves as a mounting face, and the semiconductor layer includes a p-type semiconductor sublayer, an n-type semiconductor sublayer, and a light-emitting sublayer formed between the p-type semiconductor sublayer and the n-type semiconductor sublayer.

**Claims**

1. A Group III nitride crystal substrate wherein the surface roughness $R_y$ is 5nm or less.

2. A Group III nitride crystal substrate wherein the surface roughness $R_a$ is 0.5 nm or less.

3. A Group III nitride crystal substrate according to claim 1 wherein the surface roughness Ry is more preferably 1 nm or less.

4. A Group III nitride crystal substrate according to claim 2 wherein the surface roughness Ra is more preferably 0.1 nm or less.

5. The Group III nitride crystal substrate according to any one of claims 3 to 4, wherein a principal plane of the Group III nitride crystal substrate is parallel to any plane of C-plane, A-plane, R-plane, M-plane, and S-plane in the wurtzite structure.

6. The Group III nitride crystal substrate according to any one of claims 3 to 4, wherein an off-angle formed by a principal plane of the Group III nitride crystal substrate and any plane of C-plane, A-plane, R-plane, M-plane, and S-plane in the wurtzite structure is 0.05 ° to 15 °.

7. A Group III nitride crystal substrate according to any one of claims 3 to 6, comprising:

an epitaxial layer of at least one Group III nitride layer formed on the Group III nitride crystal substrate by epitaxial growth.

8. A semiconductor device comprising the Group III nitride crystal substrate according to any one of claims 3 to 7.

9. The semiconductor device according to claim 8, further comprising:

a light-emitting element including a semiconductor layer composed of three or more sublayers formed on a principal plane of the Group III nitride crystal substrate by epitaxial growth, a first electrode formed on another principal plane of the Group III nitride crystal substrate, and a second electrode formed on the outermost semiconductor sublayer of the semiconductor layer; and
an electrical conductor mounting the light-emitting element,

wherein, in the light-emitting element, the face adjacent to the Group III nitride crystal substrate serves as a light-emitting face and the face adjacent to the outermost semiconductor sublayer serves as a mounting face, and the semiconductor layer includes a p-type semiconductor sublayer, an n-type semiconductor sublayer, and a light-emitting sublayer formed between the p-type semiconductor sublayer and the n-type semiconductor sublayer.

FIG. 1

FIG. 2

FIG. 3

FIG. 4

Europäisches
Patentamt
European
Patent Office
Office européen
des brevets

# EUROPEAN SEARCH REPORT

**Application Number**

EP 08 02 2204

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 02/101121 A (ADVANCED TECHNOLOGY MATERIALS, INC) 19 December 2002 (2002-12-19) * page 4, last paragraph - page 11, paragraph 4 * * page 13, paragraph 2 - page 16, paragraph 1 * * page 21, paragraph 2 - page 24, last paragraph; claims; figures; examples * | 1-9 | INV. C09G1/02 C30B33/00 H01L21/306 |
| A | US 4 057 939 A (BASI ET AL) 15 November 1977 (1977-11-15) * column 2, line 9 - column 5, line 64; claims; tables * | 1-9 | |
| A | WO 01/30928 A (CABOT MICROELECTRONICS CORPORATION) 3 May 2001 (2001-05-03) * page 1, lines 8-12 * * page 5, line 3 - page 15, line 16; claims; examples * | 1-9 | |
| X | EP 1 475 826 A (SUMITOMO ELECTRIC INDUSTRIES [JP]; SONY CORP [JP]) 10 November 2004 (2004-11-10) * paragraphs [0001], [0026] - [0075]; claims; figures * | 1-9 | TECHNICAL FIELDS SEARCHED (IPC) C30B C09G H01L |
| X,D | WO 01/68955 A (ADVANCED TECH MATERIALS [US]; VAUDO ROBERT P [US]; FLYNN JEFFREY S [US]) 20 September 2001 (2001-09-20) * page 6, line 4 - page 16, line 22 * * page 29, line 14 - page 32, line 11; claims 52,99 * | 1-9 | |

The present search report has been drawn up for all claims

| Place of search | Date of completion of the search | Examiner |
|---|---|---|
| Munich | 13 February 2009 | Otegui Rebollo, Juan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                   EP 08 02 2204

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2009

| Patent document cited in search report | | | Publication date | Patent family member(s) | | | Publication date |
|---|---|---|---|---|---|---|---|
| WO 02101121 | A | | 19-12-2002 | CN | 1541287 | A | 27-10-2004 |
| | | | | CN | 101220244 | A | 16-07-2008 |
| | | | | EP | 1404902 | A1 | 07-04-2004 |
| | | | | JP | 2004530306 | T | 30-09-2004 |
| | | | | TW | 226391 | B | 11-01-2005 |
| | | | | US | 2003127041 | A1 | 10-07-2003 |
| | | | | US | 2002185054 | A1 | 12-12-2002 |
| US 4057939 | A | | 15-11-1977 | CA | 1071511 | A1 | 12-02-1980 |
| | | | | DE | 2653901 | A1 | 08-06-1977 |
| | | | | FR | 2333847 | A1 | 01-07-1977 |
| | | | | GB | 1537128 | A | 29-12-1978 |
| | | | | IT | 1124778 | B | 14-05-1986 |
| | | | | JP | 941551 | C | 20-02-1979 |
| | | | | JP | 52069558 | A | 09-06-1977 |
| | | | | JP | 53020379 | B | 26-06-1978 |
| WO 0130928 | A | | 03-05-2001 | AU | 1457101 | A | 08-05-2001 |
| | | | | TW | 552299 | B | 11-09-2003 |
| EP 1475826 | A | | 10-11-2004 | CN | 1549357 | A | 24-11-2004 |
| | | | | JP | 3581145 | B1 | 27-10-2004 |
| | | | | JP | 2004356609 | A | 16-12-2004 |
| | | | | KR | 20040095138 | A | 12-11-2004 |
| | | | | TW | 239045 | B | 01-09-2005 |
| | | | | US | 2004221799 | A1 | 11-11-2004 |
| WO 0168955 | A | | 20-09-2001 | AU | 4738901 | A | 24-09-2001 |
| | | | | CN | 1426497 | A | 25-06-2003 |
| | | | | CN | 101307498 | A | 19-11-2008 |
| | | | | EP | 1264011 | A1 | 11-12-2002 |
| | | | | JP | 2003527296 | T | 16-09-2003 |
| | | | | PL | 357941 | A1 | 09-08-2004 |
| | | | | TW | 259513 | B | 01-08-2006 |
| | | | | US | 2003213964 | A1 | 20-11-2003 |
| | | | | US | 2003157376 | A1 | 21-08-2003 |
| | | | | US | 6596079 | B1 | 22-07-2003 |
| | | | | US | 6447604 | B1 | 10-09-2002 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001322899 A
- US 6596079 B
- US 6488767 B
- JP 2004311575 A